(19) **Europäisches Patentamt European Patent Office Office européen des brevets**

(11) **EP 1 724 106 B1**

(12) **EUROPEAN PATENT SPECIFICATION**

(45) Date of publication and mention of the grant of the patent:
**03.11.2010 Bulletin 2010/44**

(51) Int Cl.:
***B32B 27/08*** *(2006.01)*

(21) Application number: **06006556.2**

(22) Date of filing: **29.03.2006**

(54) **Pressure-sensitive adhesive sheet for use in dicing and method of processing products worked with it**

PSA-Folie zum zerschneiden und verarbeitungsverfahren von daraus hergestellten produkten

Feuille adhésive sensible à la pression pour découpe et methode de realisation de produits les contentant

(84) Designated Contracting States:
**AT BE BG CH CY CZ DE DK EE ES FI FR GB GR HU IE IS IT LI LT LU LV MC NL PL PT RO SE SI SK TR**

(30) Priority: **16.05.2005 JP 2005142417**
**17.01.2006 JP 2006008484**
**30.01.2006 JP 2006021027**

(43) Date of publication of application:
**22.11.2006 Bulletin 2006/47**

(60) Divisional application:
**07016590.7 / 1 880 843**

(73) Proprietor: **NITTO DENKO CORPORATION**
**Ibaraki-shi, Osaka 567-8680 (JP)**

(72) Inventors:
• **Shintani, Toshio**
**Ibaraki-shi**
**Osaka 567-8680 (JP)**

• **Takahashi, Tomokazu**
**Ibaraki-shi**
**Osaka 567-8680 (JP)**
• **Yamamoto, Syouji**
**Ibaraki-shi**
**Osaka 567-8680 (JP)**
• **Kiuchi, Kazuyuki**
**Ibaraki-shi**
**Osaka 567-8680 (JP)**
• **Asai, Fumiteru**
**Ibaraki-shi**
**Osaka 567-8680 (JP)**
• **Akazawa, Kouji**
**Ibaraki-shi**
**Osaka 567-8680 (JP)**

(74) Representative: **Müller-Boré & Partner**
**Patentanwälte**
**Grafinger Straße 2**
**81671 München (DE)**

(56) References cited:
**US-A- 5 412 035      US-A1- 2004 126 575**
**US-B1- 6 638 528**

## Description

The invention relates to a method for processing a workpiece using a pressure-sensitive adhesive sheet for use in dicing and more specifically using a pressure-sensitive adhesive sheet for use in dicing of semiconductor wafers comprising silicon, a compound semiconductor such as gallium arsenide (GaAs) or the like, semiconductor packages, glass, ceramics, or the like, and a semiconductor device produced by the above method.

Conventionally, a wafer of a semiconductor material such as silicon, germanium and GaAs is produced in a large diameter and then subjected to rear surface grinding (back grinding) so as to have a specific thickness and optionally subjected to rear surface treatment (such as etching and polishing). A pressure-sensitive adhesive sheet for dicing is then attached to the rear surface of the semiconductor wafer, and then the wafer is cut and divided (diced) into device pieces, which is followed by the processes of cleaning, expanding, picking up, and mounting.

The conventional pressure-sensitive adhesive sheet for dicing comprises a base material made of a plastic film or the like and a pressure-sensitive adhesive layer with a thickness of about 1 to 50 $\mu$m that is formed by applying a pressure-sensitive acrylic adhesive or the like to the base material and drying it. The pressure-sensitive adhesive sheet for dicing must have such a degree of adhesive force that the semiconductor wafer does not separate from it during dicing. From this stand point, for example, pressure-sensitive adhesive sheets conventionally used for dicing have an adhesive force of at least 2.5 N/25 mm tape width against 15° peeling from a silicon mirror wafer with respect to pickup (peeling rate: 150 mm/minute, attachment temperature: 23°C, peeling temperature: 23°C). On the other hand, the pressure-sensitive adhesive sheets are required to have such a week adhesive force that the sheets can be easily separated during pickup after dicing and do not damage semiconductor wafers. Additionally, a low contaminating potential such as providing no adhesive deposit on semiconductor chips should be one of the important features of the pressure-sensitive adhesive sheets for dicing. For example, Japanese Patent Application Laid-Open (JP-A) No. 2001-234136 discloses an invention that attempts to satisfy these requirements at the same time.

The pickup is performed after the process of expanding the space between the respective semiconductor chips. The expanding process facilitates the release of the semiconductor chips from the dicing pressure-sensitive adhesive sheet. This process includes the steps of straining the dicing pressure-sensitive adhesive sheet to a certain extent and lifting, in a point or line mode, the dicing pressure-sensitive adhesive sheet placed on the lower portions of the semiconductor chips to be picked up. In most current methods, semiconductor chips are vacuum-sucked and picked up from their upper sides after they are allowed to be in such a state that they can be easily released.

In recent years, however, the use of the process of attaching the pressure-sensitive adhesive sheet for dicing to a semiconductor wafer during and after grinding of the rear surface of the semiconductor wafer or within several hours after the completion of removal of the crushed layer has been increased for the purpose of an improvement in tact time and prevention of damage to thin semiconductor wafers. In the case where pasting as that described above is carried out, there is a problem that after the attachment, the adhesive force against pickup increases over time so that the pickup ability can be degraded. This could be because the pressure-sensitive adhesive sheet for dicing is attached to the ground surface (treated surface) of the semiconductor wafer in such a state that a natural oxidation film is not grown so that chemical bonds can be formed between unoxidized active Si atoms and the pressure-sensitive adhesive. Here, the ground surface in a state before a natural oxidation film has grown is referred to as active surface.

It is an object of the invention to solve the above problems and to provide: a method for processing a workpiece using a pressure-sensitive adhesive sheet for dicing that can produce good pickup performance even a long time after the pressure-sensitive adhesive sheet is attached to a semiconductor wafer immediately after its rear surface is ground (or treated).

In order to solve the above problems, the inventors have been investigated pressure-sensitive adhesive sheets for dicing and methods of processing products worked with pressure-sensitive adhesive sheets. As a result, the inventors have found that the object can be achieved using the structure as described below to complete the invention.

In order to solve the above problems, therefore, the invention is directed to a method for processing a workpiece, according to which a workpiece is processed using a pressure-sensitive adhesive sheet for use in dicing, and which is characterized by comprising: the step of grinding the rear surface of said workpiece; the step of contact-bonding said pressure-sensitive adhesive sheet for use in dicing on an active surface on the rear surface of the workpiece that has been ground, wherein the contact-bonding is carried out within one hour after said grinding of the rear surface, or the contact-bonding is carried out within one hour after a further step of removing a crushed layer that has been created on the workpiece during the grinding of the rear surface of said workpiece after the grinding of the rear surface; the step of dicing said workpiece; and the step of picking up said workpiece after dicing from the pressure-sensitive adhesive sheet for use in dicing, wherein said pressure-sensitive adhesive sheet comprises: a base film; and at least a pressure-sensitive adhesive layer provided on the base film, wherein the pressure-sensitive adhesive layer comprises an acrylic polymer that contains at least 5% by weight of a monomer unit having an alkoxyl group in its side chain.

In the above structure, the acrylic polymer forming the pressure-sensitive adhesive layer contains 5% by weight or more of a monomer unit having an alkoxyl group in its side chain. For example, therefore, even if active Si atoms exist in the attached surface of the workpiece, the formation of chemical bonds between the Si atoms and the acrylic polymer forming the pressure-sensitive adhesive layer can be suppressed. As a result, an excessive increase in the adhesive force of the pressure-sensitive adhesive layer can be prevented even after long-time attachment, and the pickup potential can remain good.

In the above structure, it is preferable for a 90 degree peeling adhesiveness, which is the adhesiveness of the above described adhesive layer to an active surface of the above described workpiece, to be 0.05 to 1 N/25 mm tape width when the sheet is peeled under the conditions of a measurement temperature of $23\pm3°C$, an angle of 15° formed between a surfaces of the pressure-sensitive adhesive layer and the silicon mirror wafer, and a peeling rate of 150 mm/minute.

The pressure-sensitive adhesive layer preferably contains at least 5% by weight of a monomer unit having nitrogen in the side chain.

The surface of the pressure-sensitive adhesive layer preferably forms a contact angle of at most 90 degrees with water.

If the contact angle with water is within the above range, the pressure-sensitive adhesive layer can facilitate the release of the worked product after dicing and maintain good pickup potential, while it can maintain its adhesive force such that the workpiece can be surely held so as not to easily separate during dicing.

The pressure-sensitive adhesive layer preferably has a loss tangent tan $\delta$ of at most 0.5 at 25°C and a loss tangent tan $\delta$ of at most 0.15 at 50°C.

If the tan $\delta$ of the pressure-sensitive adhesive layer is 0.5 or less at 25°C and 0.15 or less at 50°C, good pickup potential can be maintained even after the pressure-sensitive adhesive sheet for dicing is attached to the workpiece for a long time.

The acrylic polymer preferably has one carbon-carbon double bond in each of at least 1/100 of all side chains in its molecule.

If the pressure-sensitive adhesive layer contains a radiation-curable acrylic polymer having one carbon-carbon double bond in each of at least 1/100 of all side chains, the pressure-sensitive adhesive layer can be cured by irradiation so as to have reduced stickiness. In the process of picking up worked products from the dicing pressure-sensitive adhesive sheet after dicing, therefore, radiation may be applied so that after dicing, the worked products can easily be separated from the dicing pressure-sensitive adhesive sheet.

The pressure-sensitive adhesive layer preferably comprises a radiation-curable pressure-sensitive adhesive having a carbon-carbon double bond, and after the pressure-sensitive adhesive sheet for use in dicing is attached to a silicon mirror wafer, the pressure-sensitive adhesive layer preferably exhibits an adhesive force of at most 2.3 N/25 mm tape width when the sheet is peeled under the conditions of a measurement temperature of $23\pm3°C$, an angle of 15° formed between the surfaces of the pressure-sensitive adhesive layer and the silicon mirror wafer, and a peeling rate of 150 mm/minute.

If the adhesive force of the dicing pressure-sensitive adhesive sheet to a silicon mirror wafer is 2.3 N/25 mm tape width or less as stated above, pickup failure can be prevented during pickup.

The acrylic polymer preferably has a weight average molecular weight of at least 500,000.

The pressure-sensitive adhesive layer preferably has such releasability that after the pressure-sensitive adhesive layer is separated from the workpiece, the attached surface of the workpiece provides an at most 5% increase $\Delta C$ in surface organic contaminants.

If the dicing pressure-sensitive adhesive sheet as stated above is used, the increase $\Delta C$ in surface organic contaminants on the attached surface of the worked product can be suppressed to 5% or less after the separation, so that the so-called adhesive deposit can be reduced and that the yield of worked products can be increased.

The invention as described above is directed to a method of processing a worked product using the dicing pressure-sensitive adhesive sheet as described above, comprising steps of: contact-bonding the dicing pressure-sensitive adhesive sheet to the above described workpiece, dicing a workpiece, and then picking up worked product from the pressure-sensitive adhesive sheet.

According to this method, pickup can be easily performed even after the dicing pressure-sensitive adhesive sheet is attached to the workpiece for a long time. Thus, there is provided methods of processing worked products by which the yield can be increased.

The above described method has the step of grinding the rear surface of said workpiece, characterized in that the contact-bonding of said pressure-sensitive adhesive sheet for use in dicing to the workpiece is carried out on an active surface on the rear surface of the workpiece that has been ground. Here, active surface refers to, for example, a ground surface when a workpiece is ground, in a state before a natural oxide film has grown and active Si atoms that are not oxidized exist.

In this method, the contact-bonding of the dicing pressure-sensitive adhesive sheet to a workpiece is carried out within one hour after the above described grinding of the rear surface, or

the above described method further has the step of removing a crushed layer that has been created on the workpiece during the grinding of the rear surface of the above described workpiece after the grinding of the rear surface, wherein the contact-bonding of the dicing pressure-sensitive adhesive sheet to the workpiece is carried out within one hour after the removal of the above described crushed layer.

In this method, a semiconductor device with a thickness of less than 100 μm may be used as the workpiece. By this method, the yield can be increased even if thin fragile semiconductor devices are used. The semiconductor devices include semiconductor wafers made of silicon, germanium, GaAs, or the like.

In order to solve the above problems, the invention is also directed to a semiconductor device produced by the above method of processing a worked product.

According to the invention, the above stated means can produce the effects as mentioned below.

Since the pressure-sensitive adhesive layer of the dicing pressure-sensitive adhesive sheet according to the method of the invention comprises an acrylic polymer containing at least 5% by weight of a monomer unit having an alkoxyl group in the side chain, an excessive increase in the adhesive force of the pressure-sensitive adhesive layer can be prevented even in the case of long-time attachment to the workpiece, and the pickup potential can be maintained in a good condition. Thus, there can be provided a dicing pressure-sensitive adhesive sheet capable of increasing the yield and a process of processing products worked with the sheet.

Further objects, features and superior points of the present invention will be sufficiently understood from the following description. Advantageous effects of the present invention will be made evident from the following description with reference to the attached drawings.

Fig. 1 is a sectional view which schematically illustrates a pressure-sensitive adhesive sheet for use in dicing according to an Embodiment of the method of the present invention.

Fig. 2 is a schematic diagram showing the process of separating the pressure-sensitive adhesive sheet from a silicon mirror wafer.

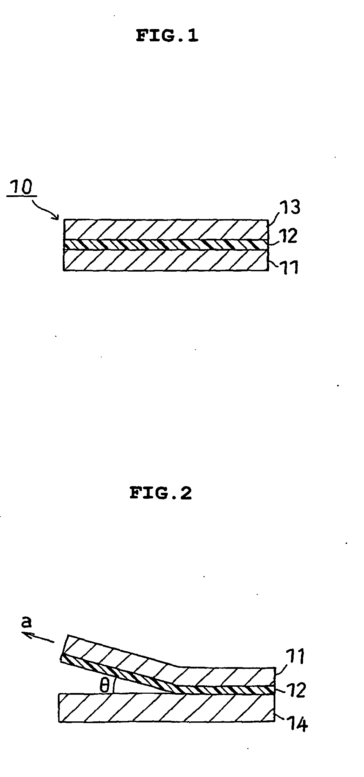

Some embodiments of the invention are described below with reference to Figs. 1 and 2. Fig. 1 is a cross-sectional view schematically showing a pressure-sensitive adhesive sheet for use in dicing (hereinafter simply referred to as "pressure-sensitive adhesive sheet") according to an embodiment of the method of the invention. Fig. 2 is a schematic diagram showing the process of separating the pressure-sensitive adhesive sheet from a silicon mirror wafer.

Referring to Fig. 1, the pressure-sensitive adhesive sheet 10 comprises a base film 11, and a pressure-sensitive adhesive layer 12 and a separator 13 which are laminated on the film 11. The pressure-sensitive adhesive sheet 10 may be kept in any appropriate shape such as a sheet shape and a roll shape depending on use. For wafer dicing applications, for example, a product that has been preliminarily cut and worked into a specific shape is preferably used. Concerning the embodiment, a mode where the pressure-sensitive adhesive layer 12 is placed only on one side of the base film 11 is specifically described, while such a mode is not intended to limit the scope of the invention. In an alternative mode, for example, the pressure-sensitive adhesive layer 12 may be placed on each of both sides of the base film 11.

The base film 11 confers strength on the dicing die-bonding film. Examples of the substrate material include polyolefins such as low-density polyethylene, linear polyethylene, middle-density polyethylene, high-density polyethylene, ultra-low-density polyethylene, random copolymerization polypropylene, block copolymerization polypropylene, homopolypropylene, polybutene, polymethyl pentene etc., polyesters such as ethylene/vinyl acetate copolymer, ionomer resin, ethylene/(meth)acrylic acid copolymer, ethylene/(meth)acrylate (random, alternating) copolymer, ethylene/butane copolymer, ethylene/hexene copolymer, polyurethane, polyethylene terephthalate, polyethylene naphthalate etc., polycarbonate, polyimide, polyether ether ketone, polyimide, polyether imide, polyamide, every aromatic polyamide, polyphenyl sulfide, aramid (paper), glass, glass cloth, fluorine resin, polyvinyl chloride, polyvinylidene chloride, cellulose resin, silicone resin, metal (foil), paper etc. The material of the substrate material includes polymers such as those crosslinked from the resin described above. The exemplary material constituting the substrate material may be used after grafting a functional group, a functional monomer or a modifying monomer onto it if necessary.

If necessary, the surface of the base film 11 produced as described above may be subjected to any conventional physical or chemical treatment such as mat treatment, corona discharge treatment, primer treatment, and crosslinking treatment.

The same or different kinds of base film 11 can be suitably selected and used. The substrate material may be a single layer or multilayer or may be a blend substrate material having two or more kinds of resins dry-blended therein. The multilayer film can be produced from the above resin etc. by a conventional film lamination method such as co-extrusion method, dry lamination method etc. The base film 11 can be provided thereon with a evaporated layer of about 30 to 500 Å consisting of an electroconductive material such as a metal, an alloy and an oxide thereof in order to confer antistatic performance. The base film 11 may be a single layer or a multilayer consisting of two or more layers. When the pressure-sensitive adhesive layer 12 is a radiation-curing adhesive layer, the substrate material permitting radiations such as X-ray, UV ray, electron beam etc. to pass therethrough at least partially is used.

The thickness of the base film 11 can be suitably determined without particular limitation, and is generally preferably about 10 to 300 $\mu$m, more preferably 30 to 200 $\mu$m.

The method of making a film of the base film 11 can be carried out by a conventionally known film-making method. For example, calender film making, casting film making, inflation extrusion, T-die extrusion etc. can be preferably used.

The base film 11 may be a single layer or multilayer or may be a blend substrate material having two or more kinds of resins dry-blended therein. The multilayer film can be produced from the above resin etc. by a conventional film lamination method such as co-extrusion method, dry lamination method etc. If necessary, the surfaces of the base film 11 may be subjected to a conventional physical or chemical treatment such as matting treatment, corona discharge treatment, primer treatment, or crosslinking treatment.

The pressure-sensitive adhesive layer 12 comprises an acrylic polymer. The acrylic polymer serves as a base polymer and it is formed so as to include no less than 5 wt % of a monomer unit having an alkoxyl group on its side chain. It is preferable for it to be formed so as to include no less than 10 wt %, and more preferably, include no less than 25 wt %. Even if active Si atoms exist in the attached surface of the workpiece, the monomer unit having the alkoxyl group in the side chain can suppress chemical bonding between the atoms and the acrylic polymer forming the pressure-sensitive adhesive layer 12. Thus, even after the sheet is attached for a long time, the pressure-sensitive adhesive layer 12 can be prevented from having an excessively increased adhesive force so that the pickup performance can be kept good.

It is preferable for the 90 degree peeling adhesiveness of the pressure-sensitive adhesive layer 12 to the active surface of the above described workpiece to be 0.05 to 1 N/25 mm (tape width), and it is more preferable for it to be 0.1 to 0.5 N/25 mm tape width. The adhesiveness of the pressure-sensitive adhesive layer 12 to the active surface is controlled so as to be within the above described range of numeral values, and thereby, a state of easy pick-up can be maintained.

The pressure-sensitive adhesive layer 12 preferably has a thickness of 1 to 50 $\mu$m. The workpiece attached to the pressure-sensitive adhesive sheet 10 can sometimes vibrate during dicing. At that time, if the amplitude of the vibration is large, the chips cut from the workpiece can be chipped (chipping can occur). According to the invention, however, the pressure-sensitive adhesive layer 12 with a thickness of 50 $\mu$m or less can suppress an excessive increase in the amplitude of the vibration, which occurs in the process of dicing the workpiece. Thus, the so-called chipping, in which some of the chips produced by cutting are chipped, can be reduced. If the pressure-sensitive adhesive layer 12 has a thickness of 1 $\mu$m or more, the workpiece can be surely held so as not to easily separate during dicing. The thickness of the pressure-sensitive adhesive layer 12 is more preferably from 3 to 20 $\mu$m. In this range, chipping can be further reduced, and the workpiece can be more surely fixed during dicing, so that the occurrence of dicing defects can be prevented.

The surface of the pressure-sensitive adhesive layer 12 preferably forms a contact angle of 90 degrees or less, more preferably of more than 40 degrees and not more than 87 degrees, with water. In such a range, the pressure-sensitive adhesive layer 12 can maintain the adhesive force such that the workpiece can be surely held so as not to easily separate during dicing, and the layer 12 allows easy release of the worked product after dicing so that good pickup potential can be maintained. If the contact angle is 40 degrees or less, the polymerization of the polymer for forming the pressure-sensitive adhesive layer 12 can be sometimes insufficient. The value of the contact angle may be increased or decreased within the above range depending on the change of various conditions such as the type and mixing ratio of the monomer components for the polymer, the type and mixing ratio of additives, the molecular weight of the polymer, and the conditions for the production thereof.

The pressure-sensitive adhesive layer 12 preferably has a loss tangent (tan $\delta$) of 0.5 or less at 25°C and a frequency of 1 Hz and a loss tangent (tan $\delta$) of 0.15 or less at 50°C and a frequency of 1 Hz. In this range, good pickup potential can be maintained even after attachment for a long time. Within the above range, if the pressure-sensitive adhesive layer 12 has a loss tangent (tan $\delta$) of 0.01 or more at 25°C and a frequency of 1 Hz and a loss tangent (tan $\delta$) of 0.001 or more at 50°C and a frequency of 1 Hz, it can well maintain its wettability for the workpiece and can reduce the incidence of voids. The loss tangent (tan $\delta$) may be represented by the formula tan $\delta$ = G''/G', wherein G' is the storage modulus of the pressure-sensitive adhesive layer 12, and G'' is the loss modulus thereof.

The adhesive force of the pressure-sensitive adhesive layer 12 is preferably 2.3 N/25 mm tape width or less, more preferably 2.0 N/25 mm tape width or less. An adhesive force of at most 2.3 N/25 mm tape width can produce good pickup performance and reduce the incidence of adhesive deposit. The adhesive force value of the pressure-sensitive adhesive layer 12 may be increased or decreased within the above range, for example, in the same manner as for the contact angle. The adhesive force of the pressure-sensitive adhesive layer 12 is a value that is determined by a process including the steps of attaching the layer 12 to a silicon mirror wafer 14 as shown in Fig. 2 and then peeling the pressure-sensitive adhesive sheet 10 at a peeling rate of 150 mm/minute in the direction indicated by the arrow a at a measurement temperature of 23±3°C, while setting the angle $\theta$ between the surfaces of the pressure-sensitive adhesive layer 12 and the silicon mirror wafer 14 at 15°. The adhesive force of the pressure-sensitive adhesive layer 12 is determined using the silicon mirror wafer 14, because the surface of the silicon mirror wafer 14 has a uniform roughness and is relatively smooth, and the wafer 14 is made of the same type of material as the workpiece to be diced and picked up, such as a semiconductor wafer. In a standard mode, the adhesive force is measured at a temperature of $23\pm3°C$, because the pickup is generally performed at room temperature (23°C).

The pressure-sensitive adhesive layer 12 preferably has such releasability that an increase $\Delta C$ in surface organic contaminants on the attached surface of a semiconductor wafer consisting of silicon is 5% or less. The pressure-sensitive adhesive layer 12 with such releasability can reduce the incidence of adhesive deposit on the semiconductor chips after pickup. The value (%) of the increase $\Delta C$ in surface organic contaminants may be increased or decreased within the above range, for example, in the same manner as for the contact angle. The increase $\Delta C$ (%) in surface organic contaminants may be a value obtained by subtracting $C_2$ (%) from $C_1$ (%), wherein $C_1$ is the value of the content of surface organic contaminants at the time when the pressure-sensitive adhesive sheet 10 is peeled at 23°C immediately before pickup after the pressure-sensitive adhesive sheet 10 is attached to the semiconductor wafer at 23°C and the semiconductor wafer is diced, and $C_2$ is the value of the content of surface organic contaminants of the semiconductor wafer itself. If the pressure-sensitive adhesive layer 12 comprises a radiation-curable pressure-sensitive adhesive as described later, the increase $\Delta C$ in surface organic contaminants should be a value obtained at the time when the sheet is peeled after the radiation is applied.

Examples of the monomer containing an alkoxyl group in the side chain include methoxyethyl (meth)acrylate and ethoxy (meth)acrylate. The term '(meth)acrylate' means that it includes any of the acrylate ester and the methacrylate ester. Concerning the invention, "(meth)" has the same meaning in all contexts.

The acrylic polymer preferably contains at least 5 parts by weight of a monomer unit having nitrogen in the side chain. It is more preferable for it to include no less than 10 wt %, and it is most preferable for it to include no less than 20 wt %. Examples of the monomer having nitrogen in the side chain include (meth)acrylamide, N-hydroxymethylamide (meth)acrylate, alkylaminoalkyl (meth)acrylates (such as dimethylaminoethyl methacrylate and tert-butylaminoethyl methacrylate), N-vinylpyrrolidone, acryloyl morpholine, acrylonitrile, and N,N-dimethylacrylamide.

The acrylic polymer may optionally contain a unit corresponding to a different monomer component copolymerizable with the above-mentioned alkyl ester of (meth)acrylic acid or cycloalkyl ester thereof in order to improve the cohesive force, heat resistance or some other property of the polymer. Examples of such a monomer component include carboxyl-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride, and itaconic anhydride; hydroxyl-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxylmethylcyclohexyl)methyl (meth)acrylate; sulfonic acid group containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group containing monomers such as 2-hydroxyethylacryloyl phosphate; acrylamide; and acrylonitrile. These copolymerizable monomer components may be used alone or in combination of two or more thereof. The amount of the copolymerizable monomer(s) to be used is preferably 40% or less by weight of all the monomer components.

The acrylic polymer may optionally contain, as a copolymerizable monomer component, a polyfunctional monomer in order to crosslink the polymer. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate, polyester (meth)acrylate, and urethane (meth)acrylate. These polyfunctional monomers may be used alone or in combination of two or more thereof. The amount of the polyfunctional monomer(s) to be used is preferably 30% or less by weight of all the monomers from the viewpoint of the viscosity of the adhesive layer.

The acrylic polymer can be obtained by polymerizing a single monomer selected from monomers as described above, or a mixture of two or more monomers selected therefrom. The polymerization may be performed by any method selected from solution polymerization, emulsion polymerization, bulk polymerization, suspension polymerization and other polymerization methods. The acrylic polymer is preferably an acrylic polymer containing a low molecular weight substance in only a small amount in order to prevent contamination of a clean object wherein a semiconductor element or the like is to be stuck/fixed. From this viewpoint, the number-average molecular weight of the acrylic polymer is preferably about 500,000 or more, more preferably from about 800,000 to 3,000,000.

For the above-mentioned adhesive, an external crosslinking agent may be appropriately used in order to heighten the number-average molecular weight of the acrylic polymer or the like as the base polymer. A specific example of the method of using the external crosslinking agent may be a method of adding, to the base polymer, the so-called crosslinking agent, such as a polyisocyanate compound, epoxy compound, aziridine compound or melamine type crosslinking agent, so as to cause crosslinking reaction. In the case that the external crosslinking agent is used, the amount thereof is appropriately decided in accordance with the balance with the amount of the base polymer to be crosslinked and further the use purpose of the adhesive. In general, 0.01 to 5 parts by weight of the external crosslinking agent is preferably added to 100 parts by weight of the base polymer. If necessary, any conventional additive such as a tackifier, an antioxidant, a filler, and a colorant may be added in addition to the above components.

The pressure-sensitive adhesive layer 12 is preferably formed of a radiation-curable pressure-sensitive adhesive for the purpose of preventing separation of chips during dicing and improving releasability from chips during pickup. If the radiation-curable pressure-sensitive adhesive is used and radiation is applied thereto so as to increase its degree of crosslinking, the adhesive force of the pressure-sensitive adhesive layer 12 can be easily reduced. Examples of the radiation include ultraviolet rays and electron beams.

Any radiation-curable pressure-sensitive adhesive that has any radiation-curable functional group such as a carbon-carbon double bond and exhibits stickiness may be used without limitation. In particular, one molecule of the radiation-curable pressure-sensitive adhesive preferably has at least six carbon-carbon double bonds on average. The radiation-curable pressure-sensitive adhesive may be of a mixture-type that contains the acrylic polymer and a radiation-curable monomer or oligomer component. Examples of the radiation-curable monomer or oligomer component for the mixture include trimethylolpropane tri(meth)acrylate, pentaerythritol tri(meth)acrylate, tetraethylene glycol di(meth)acrylate, 1,6-hexanediol (meth)acrylate, neopentyl glycol di(meth)acrylate, esters of (meth)acrylic acid and polyhydric alcohol; ester acrylate oligomers; 2-propenyl-3-butenyl cyanurate; and isocyanurate and isocyanurate compounds. The radiation-curable pressure-sensitive adhesive having at least six carbon-carbon double bonds on average per molecule may be dipentaerythritol hexa(meth)acrylate or the like.

While radiation-curable monomer or oligomer component may be added in any amount, the pressure-sensitive adhesive preferably contains 40 to 75% by weight of, more preferably 50 to 70% by weight, of the monomer or oligomer component, in view of the reduction in adhesive force for peeling from the worked product in the process of pickup after the application of radiation. The radiation-curable monomer or oligomer component may have any viscosity. The radiation-curable monomer or oligomer component may be of a single type or a mixture of two or more types.

The radiation-curable pressure-sensitive adhesive may also contain a base polymer having a carbon-carbon double bond(s) in its side chain or main chain or at the terminal of its main chain. Such a base polymer preferably comprises a basic skeleton of the above acrylic polymer. In this case, the radiation-curable monomer or oligomer component may not particularly be added and may be used optionally.

The acrylic polymer is preferably a double bond-containing acrylic polymer having one carbon-carbon double bond in each of at least 1/100 of all side chains in its molecule. Such an acrylic polymer may also have a carbon-carbon double bond(s) in its main chain or at the terminal of its main chain. The acrylic polymer having a carbon-carbon double bond(s) does not need to be mixed with the low-molecular-weight component such as the oligomer component and the like or does not need to be mixed with a large amount of the low-molecular-weight component, so that there can be no movement of the oligomer component or the like in the pressure-sensitive adhesive over time and that the pressure-sensitive adhesive layer 12 can be formed to have a stable layer structure.

The method for introducing a carbon-carbon double bond into any one of the above-mentioned acrylic polymers is not particularly limited, and may be selected from various methods. The introduction of the carbon-carbon double bond into a side chain of the polymer is easier in molecule design. The method is, for example, a method of copolymerizing a monomer having a functional group with an acrylic polymer, and then causing the resultant to condensation-react or addition-react with a compound having a functional group reactive with the above-mentioned functional group and a carbon-carbon double bond while keeping the radial ray curability of the carbon-carbon double bond. For example, the method of controlling the introduction of carbon-carbon double bonds into at least 1/100 of all side chains includes the step of appropriately controlling the addition amount of the compound to be subjected to condensation or addition reaction.

Examples of the combination of these functional groups include a carboxylic acid group and an epoxy group; a carboxylic acid group and an aziridine group; and a hydroxyl group and an isocyanate group. Of these combinations, the combination of a hydroxyl group and an isocyanate group is preferable from the viewpoint of the easiness of reaction tracing. If the above-mentioned acrylic polymer, which has a carbon-carbon double bond, can be produced by the combination of these functional groups, each of the functional groups may be present on any one of the acrylic polymer and the above-mentioned compound. It is preferable for the above-mentioned preferable combination that the acrylic polymer has the hydroxyl group and the above-mentioned compound has the isocyanate group. Examples of the isocyanate compound in this case, which has a carbon-carbon double bond, include methacryloyl isocyanate, 2-methacryloyloxyethyl isocyanate, and m-isopropenyl-a,a-dimethylbenzyl isocyanate. The used acrylic polymer may be an acrylic polymer copolymerized with any one of the hydroxyl-containing monomers exemplified above, or an ether compound such as 2-hydroxyethyl vinyl ether, 4-hydroxybutyl vinyl ether or diethylene glycol monovinyl ether.

The carbon-carbon double bond-containing acrylic polymer may be used alone for the radiation-curable pressure-sensitive adhesive. The radiation-curable monomer or oligomer component may also be added and used in such a degree that the characteristics are not degraded. The amount of the radiation-curable oligomer or the like to be added is generally from 10 to 300 parts by weight, preferably from 30 to 150 parts by weight, based on 100 parts by weight of the acrylic polymer.

In the case that the radial ray curable adhesive is cured with ultraviolet rays or the like, a photopolymerization initiator is incorporated into the adhesive. Examples of the photopolymerization initiator include benzoin alkyl ethers such as benzoin methyl ether, benzoisopropyl ether, benzoin isopropyl ether, and benzoin isobutyl ether; aromatic ketones such as benzil, benzoin, benzophenone, and a-hydroxycyclohexyl phenyl ketone; aromatic ketals such as benzyl dimethyl ketal; polyvinyl benzophenone; and thioxanthones such as chlorothioxanthone, dodecylthioxanthone, dimethylthioxanthone, and diethylthioxanthone.

The amount of the photopolymerization initiator to be blended is, for example, from about 0.1 to 10 parts by weight, preferably from 30 to 150 parts by weight, based on 100 parts by weight of the acrylic polymer or the like which constitutes the adhesive as a base polymer.

A heat-peelable pressure-sensitive adhesive may be used for the pressure-sensitive adhesive layer 12 in place of the radiation-curable pressure-sensitive adhesive. The heat-peelable pressure-sensitive adhesive can also make the release of worked products easy and produce good pickup performance.

The heat-peelable pressure-sensitive adhesive may be a heat-foamable pressure-sensitive adhesive comprising an acrylic polymer or the like and heat-expandable fine particles added thereto. After the desired adhesion to the workpiece is achieved, the pressure-sensitive adhesive layer 12 containing the heat-expandable fine particles is heated so as to be foamed or expanded and to have a modified irregular surface. As a result, the adhesion area to the worked product and the adhesive force are reduced so that the separation can be easily performed.

The heat-expandable fine particles may be of any type and may be selected and used from various inorganic or organic types of heat-expandable microspheres. Expandable fine particles comprising a micro-encapsulated heat-expandable substance may also be used.

Concerning the embodiment, the case where the pressure-sensitive adhesive layer 12 is a single layer has been specifically described. However, the invention is not limited to such a case, and the pressure-sensitive adhesive layer 12 may be a laminate of a plurality of layers.

Conventional methods may be used to form the pressure-sensitive adhesive layer 12 on the base film 11. For example, appropriate methods may be used such as a method of directly applying the component material for the pressure-sensitive adhesive layer 12 to the base film 11 and a method including the steps of applying the component material to a release agent-coated sheet, drying the applied component material to form the pressure-sensitive adhesive layer 12, and then transferring the layer 12 onto the base film 11.

The separator 13 has the functions of protecting the pressure-sensitive adhesive layer 12, forming a label, and smoothing the surface of the pressure-sensitive adhesive layer 12 and is optionally provided for such purposes.

The material constituting the separator includes paper and synthetic resin film of polyethylene, polypropylene, polyethylene terephthalate or the like. The surface of the separator may be subjected if necessary to release treatment such as silicone treatment, long-chain alkyl treatment, fluorine treatment etc. for improving releasability from the pressure-sensitive adhesive layer. If necessary, the adhesive sheet may be subjected to UV protection treatment so that it does not react with environmental UV rays. The thickness of the separator is usually 10 to 200 $\mu$m, preferably about 25 to 100 $\mu$m.

A description is then provided of a method of processing products worked with the pressure-sensitive adhesive sheet 10 according to the embodiment. In the description below, a case where a semiconductor wafer is used as the workpiece is provided as an example.

The pressure-sensitive adhesive sheet 10 of the method of the invention is attached to a semiconductor wafer such as a semiconductor component (a mounting process), and then used in a dicing process and a picking-up process. The mounting process may be performed by superposing the semiconductor wafer and the pressure-sensitive adhesive sheet 10 in such a manner that the pressure-sensitive adhesive layer 12 side provides the attached face and by pressing the sheet 10 with pressing means such as a pressure roller. The above described steps are carried out within one hour after grinding of the rear surface of the semiconductor wafer or within one hour after the completion of removal of the crushed layer. In this case, a natural oxide film is not grown on the surface for contact-bonding on the semiconductor wafer side, which is a so-called active surface where active Si atoms that are not oxidized exist, and even in this state, an adhesive sheet 10 according to the method of the present invention can allow for easy pick-up. Here, the crushed layer is removed by being mechanically, chemically or mechanically and chemically processed, and more specifically, the process includes dry polishing, CMP, wet etching, dry etching and the like. In addition, the step of mounting can also be carried out by making a semiconductor wafer and an adhesive sheet 10 overlap as described above in a container where pressure can be applied (an autoclave, for example), and applying pressure within the container. In this process, attachment may be performed while a pressure is applied from pressing means. Alternatively, in a vacuum chamber, attachment may be performed as mentioned above. The attachment may be performed at any temperature but preferably at a temperature of 20 to 80°C.

The dicing process is performed in order to dice the semiconductor wafer into semiconductor chips. For example, the dicing is performed from the circuit surface side of the semiconductor wafer according to conventional techniques. In the dicing process, the semiconductor wafer is cut into a specific size with a blade rotating at high speed. For example, this process may use the so-called full-cut method or the like in which the pressure-sensitive adhesive sheet 10 is also cut. Any dicing machine including any conventional machine may be used in this process. The semiconductor wafer is bonded and fixed with the pressure-sensitive adhesive sheet 10 so that chipping and sputtering of chips and damage to the semiconductor wafer can be suppressed.

The pickup of the semiconductor chips is performed in order to separate the bonded and fixed semiconductor chips from the pressure-sensitive adhesive sheet 10. Any pickup method including any conventional pickup method may be used. For example, the pickup method may include the steps of pushing each semiconductor chip upward from the pressure-sensitive adhesive sheet 10 side by means of a needle and picking up the pushed semiconductor chip with a pickup device.

If the pressure-sensitive adhesive sheet 10 used in the process have the radiation-curable pressure-sensitive adhesive layer or the heat-releasable pressure-sensitive adhesive layer, the pressure-sensitive adhesive layer 12 may be irradiated or heat-treated. This technique reduces the stickiness and facilitates the pickup procedure. In the case of the radiation-curable pressure-sensitive adhesive layer, the conditions for the irradiation such as intensity and time of irradiation may be set at any appropriate conditions as needed. The heat-releasable pressure-sensitive adhesive layer is heated so that the heat-foamable or expandable component allows the pressure-sensitive adhesive layer to expand, which can significantly reduce the area of contact with the semiconductor chips. This reduces the adhesive force of the pressure-sensitive adhesive sheet 10 to the semiconductor chips and facilitates the separation of the pressure-sensitive adhesive sheet 10 from the semiconductor chips. Thus, the semiconductor chips can be picked up without being damaged. The conditions for the heat treatment such as heating temperature and heating time may be set at any appropriate conditions as needed.

While the pressure-sensitive adhesive sheet according to the method of the invention has been described above using the example with a workpiece of a semiconductor wafer, the invention is not limited to such a case, and it may be used for the dicing of any other material such as semiconductor packages, glass and ceramics.

Preferred examples of the invention are described in detail for the purpose of illustration. The materials, addition amounts and so on as shown in the examples are not intended to limit the scope of the invention and are mere examples for illustration, unless otherwise specifically stated.

Example 1

A 70 $\mu$m-thick film made of linear low-density polyethylene was used as a base film. One side of the film was corona-treated.

In ethyl acetate, 75 parts by weight of methyl acrylate, 10 parts by weight of methoxyethyl acrylate, 10 parts by weight of N-vinylpyrrolidone, and 5 parts by weight of 2-hydroxyethyl acrylate were copolymerized according to a conventional method, which provided a solution containing an acrylic copolymer with a weight average molecular weight of 500,000 in which the NCO groups of 2-methacryloyloxyethylene isocyanate were added to 90% of the terminal OH groups in the side chain of 2-hydroxyethyl acrylate and which had a carbon-carbon double bond at its terminal.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), and 2 parts by weight of a polyisocyanate compound (Coronate L (trade name) manufactured by Nippon Polyurethane Industry Co., Ltd.) so that a solution of an ultraviolet-radiation-curable pressure-sensitive acrylic adhesive was obtained.

The prepared ultraviolet-radiation-curable pressure-sensitive acrylic adhesive solution was applied to the corona-treated surface of the film and then crosslinked at 80°C for 10 minutes so that a 5 pm-thick ultraviolet-radiation-curable pressure-sensitive adhesive layer was formed. A separator was attached to the surface of the radiation-curable pressure-sensitive adhesive layer to form an ultraviolet-radiation-curable pressure-sensitive adhesive sheet for dicing.

Example 2

In ethyl acetate, 75 parts by weight of methyl acrylate, 10 parts by weight of methoxyethyl acrylate, 5 parts by weight of N-vinylpyrrolidone, and 10 parts by weight of 2-hydroxyethyl acrylate were copolymerized according to a conventional method, which provided a solution containing an acrylic copolymer with a weight average molecular weight of 600,000 in which the NCO groups of 2-methacryloyloxyethylene isocyanate were added to 90% of the terminal OH groups in the side chain of 2-hydroxyethyl acrylate and which had a carbon-carbon double bond at its terminal.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), and 2 parts by weight of a polyisocyanate compound (Coronate L (trade name) manufactured by Nippon Polyurethane Industry Co., Ltd.) so that a solution of an ultraviolet-radiation-curable pressure-sensitive acrylic adhesive was obtained.

An ultraviolet-radiation-curable pressure-sensitive adhesive sheet for dicing according to this example was then prepared using the process of Example 1 except that the above prepared solution of the ultraviolet-radiation-curable pressure-sensitive acrylic adhesive was alternatively used.

Example 3

In ethyl acetate, 40 parts by weight of methyl acrylate, 30 parts by weight of methoxyethyl acrylate, 20 parts by weight of acryloylmorpholine, and 10 parts by weight of 2-hydroxyethyl were copolymerized according to a conventional method, which provided a solution containing an acrylic copolymer with a weight average molecular weight of 500,000 in which the NCO groups of 2-methacryloyloxyethylene isocyanate were added to 90% of the terminal OH groups in the side chain of 2-hydroxyethyl acrylate and which had a carbon-carbon double bond at its terminal.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), and 2 parts by weight of a polyisocyanate compound (Coronate L (trade name) manufactured by Nippon Polyurethane Industry Co., Ltd.) so that a solution of an ultraviolet-radiation-curable pressure-sensitive acrylic adhesive was obtained.

An ultraviolet-radiation-curable pressure-sensitive adhesive sheet for dicing according to this example was then prepared using the process of Example 1 except that the above prepared solution of the ultraviolet-radiation-curable pressure-sensitive acrylic adhesive was alternatively used.

Comparative Example 1

In ethyl acetate, 95 parts by weight of methyl acrylate and 5 parts by weight of acrylic acid were copolymerized according to a conventional method, which provided a solution containing an acrylic copolymer with a weight average molecular weight of 800,000.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), and 2 parts by weight of a polyisocyanate compound (Coronate L (trade name) manufactured by Nippon Polyurethane Industry Co., Ltd.) so that a solution of an ultraviolet-radiation-curable pressure-sensitive acrylic adhesive was obtained.

An ultraviolet-radiation-curable pressure-sensitive adhesive sheet for dicing according to this comparative example was then prepared using the process of Example 1 except that the above prepared solution of the ultraviolet-radiation-curable pressure-sensitive acrylic adhesive was alternatively used.

Comparative Example 2

In ethyl acetate, 60 parts by weight of methyl acrylate, 35 parts by weight of 2-ethylhexyl acrylate and 5 parts by weight of acrylic acid were copolymerized according to a conventional method, which provided a solution containing an acrylic copolymer with a weight average molecular weight of 700,000.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), and 2 parts by weight of a polyisocyanate compound (Coronate L (trade name) manufactured by Nippon Polyurethane Industry Co., Ltd.) so that a solution of an ultraviolet-radiation-curable pressure-sensitive acrylic adhesive was obtained.

An ultraviolet-radiation-curable pressure-sensitive adhesive sheet for dicing according to this comparative example was then prepared using the process of Example 1 except that the above prepared solution of the ultraviolet-radiation-curable pressure-sensitive acrylic adhesive was alternatively used.

Comparative Example 3

In ethyl acetate, 87 parts by weight of methyl acrylate, 3 parts by weight of N-vinylpyrrolidone, and 10 parts by weight of 2-hydroxyethyl acrylate were copolymerized according to a conventional method, which provided a solution containing an acrylic copolymer with a weight average molecular weight of 500,000 in which the NCO groups of 2-methacryloyloxyethylene isocyanate were added to 90% of the terminal OH groups in the side chain of 2-hydroxyethyl acrylate and which had a carbon-carbon double bond at its terminal.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), and 2 parts by weight of a polyisocyanate compound (Coronate L (trade name) manufactured by Nippon Polyurethane Industry Co., Ltd.) so that a solution of an ultraviolet-radiation-curable pressure-sensitive acrylic adhesive was obtained.

An ultraviolet-radiation-curable pressure-sensitive adhesive sheet for dicing according to this comparative example was then prepared using the process of Example 1 except that the above prepared solution of the ultraviolet-radiation-curable pressure-sensitive acrylic adhesive was alternatively used.

Comparative Example 4

In ethyl acetate, 95 parts by weight of methyl acrylate and 5 parts by weight of acrylic acid were copolymerized according to a conventional method, which provided a solution containing an acrylic copolymer with a weight average molecular weight of 800,000.

To the acrylic copolymer-containing solution were then added 130 parts by weight of an ultraviolet-radiation-curable oligomer (with a viscosity of 10 Pa·sec at 25°C) produced by the reaction of pentaerythritol triacrylate with diisocyanate, 3 parts by weight of a photopolymerization initiator (Irgacure 651 (trade name) manufactured by Ciba Specialty Chemicals Inc.), 2 parts by weight of a polyisocyanate compound (Coronate L (trade name) manufactured by Nippon Polyurethane Industry Co., Ltd.), and 2 parts by weight of polyoxyethylene alkyl ether (Noigen ET-147 (trade name) manufactured by DAI-ICHI KOGYO SEIYAKU CO., LTD.) so that a solution of an ultraviolet-radiation-curable pressure-sensitive acrylic adhesive was obtained.

An ultraviolet-radiation-curable pressure-sensitive adhesive sheet for dicing according to this comparative example was then prepared using the process of Example 1 except that the above prepared solution of the ultraviolet-radiation-curable pressure-sensitive acrylic adhesive was alternatively used.

Adhesiveness to Active Surface

Each of the pressure sensitive adhesive sheets for dicing obtained in Examples and Comparative Examples was cut into 25 mm tape-width strips. The strip were attached to the ground surface of a 6 inch semiconductor wafer of which the rear surface was ground(with a thickness of 400 $\mu$m) at 23°C$\pm$3°C immediately after the grinding (within 5 minutes after the completion of the grinding), and then allowed to stand under room temperature atmosphere for 30 minutes. Ultraviolet light was then applied from the rear side of the pressure sensitive adhesive sheet for dicing (at an irradiation intensity of 500 mJ/cm$^2$ for an irradiation time of 20 seconds). After that, the angle θ between the surface of the adhesive layer and the ground surface was set to 90 °, and the pulling speed in this state was set to 300 mm/minute. As a result of the measurement, adhesive force values of no less than 0.05 N/25 mm tape width or no greater than 1.0 N/25 mm tape width were evaluated as good, while those not in this numerical range were evaluated as poor. The results are shown in Table 2 below. Here, the conditions for grinding the rear surface were as follows.

Conditions for Grinding Rear Surface

Grinder: DFG-840, made by Disco Corporation
First axis: grinding stone #600 (number of revolutions: 4800 rpm; down speed: P1: 3.0 $\mu$m/sec, P2: 2.0 $\mu$m/sec, P3: 1.0 $\mu$m/sec)
Second axis: grinding stone #2000 (number of revolutions: 5500 rpm; down speed: P1: 0.8 $\mu$m/sec, P2: 0.6 $\mu$m/sec, P3: 0.5 $\mu$m/sec)

In the grinding of the rear surface, a semiconductor wafer was ground using the first axis in such a manner that the final thickness became 400 $\mu$m, after a thickness of 30 $\mu$m was first ground off using the second axis.

Pickup Evaluation

Each of the pressure sensitive adhesive sheets produced in Examples and Comparative Examples was mounted on the ground surface of a 6 inch semiconductor wafer (with a thickness of 100 $\mu$m) at 23°C immediately after the grinding (within 5 minutes after the completion of the grinding). The semiconductor wafer was then diced into semiconductor chips under the conditions below.

After 6 hours or one week from the mounting, ultraviolet light was applied from the rear side of the sheet (at an irradiation intensity of 500 mJ/cm$^2$ for an irradiation time of 20 seconds). Any 50 semiconductor chips were then picked up (separated) under the conditions below, and the successfully picked up chips were counted. The case where all the semiconductor chips were successfully picked up was evaluated as good, and the other cases as poor. The results are shown in Table 1 below.

Dicing Conditions

Dicer: DFD-651 manufactured by DISCO Corporation
Blade: 27HECC manufactured by DISCO Corporation
The number of revolutions of the blade: 40,000 rpm
Dicing speed: 120 mm/sec
Dicing depth: 25 $\mu$m
Cutting mode: down cutting
Dicing size: 5.0x5.0 mm

Pickup Conditions

Die bonder: NEC Machinery Corporation, CPS-100
The number of pins: 4
Pin interval: 3.5x3.5 mm
Pin tip curvature: 0.250 mm
Pin pushing amount: 0.50 mm
Suck holding time: 0.2 seconds
Expanding amount: 3 mm

Evaluation of Adhesive Force against 15° Peeling

Each of the pressure sensitive adhesive sheets for dicing obtained in Examples and Comparative Examples was cut into 25 mm tape-width strips. The strip was attached to a silicon mirror wafer (mirror-finished at 23°C (room temperature, CZN<100>2.5-3.5 (4 inch) (trade name) manufactured by Shinetsu Semiconductor Co. Ltd.) and then allowed to stand under room temperature atmosphere for 30 minutes. Ultraviolet light was then applied from the rear side of the pressure sensitive adhesive sheet for dicing (at an irradiation intensity of 500 mJ/cm$^2$ for an irradiation time of 20 seconds).
After the UV irradiation, the pressure sensitive adhesive sheet for dicing was peeled in a thermostatic chamber at 23°C in the same manner as shown in Fig. 2, namely peeled in the direction indicated by the arrow a in such a manner that the surface of the pressure sensitive adhesive formed an angle $\theta$ of 15° with the surface of the silicon mirror wafer. In this process, the peeling rate was set at 150 mm/minute. As a result of the measurement, adhesive force values of 2.3 N/25 mm tape width or less were evaluated as good, while those of more than 2.3 N/25 mm tape width were evaluated as poor. The results are shown in Table 1 below.

Evaluation for Mirror Silicon Wafer by Increase in Surface Organic Contaminants ($\Delta$C)

Each of the pressure sensitive adhesive sheets for dicing obtained in Examples and Comparative Examples was attached to the silicon mirror wafer and allowed to stand for one hour. The sheet was then peeled according to the above adhesive force measurement test, and the surface of the silicon wafer was measured for surface carbon atom ratio $C_1$ (%) with an ESCA system. The surface of the original silicon mirror wafer was also measured for surface carbon atom ratio $C_2$ (%) with the ESCA system. The measurement conditions were as shown below.
Using the formula below, an increase in surface organic contaminants ($\Delta$C) was then calculated from the respective $C_1$ (%) and $C_2$ (%) values. As a result of the calculation, a $\Delta$C of 5% or less was evaluated as good, and a $\Delta$C of more than 5% as poor. The results are shown in Table 1 below.

## $\Delta C$=Surface Carbon Atom Ratio $C_1$ (%)-Surface Carbon Atom Ratio $C_2$ (%)

Measurement Conditions for ESCA Surface Analysis

System: Quantum 2000 manufactured by ULVAC-PHI, Inc.
X-ray setting: 200 $\mu m\phi$ [30 W (15 kV)] point analysis
X-ray source: monochrome AIKa
Photoelectron taking angle: 45°

Measurement of Viscoelasticity of Pressure Sensitive Adhesive Layer

Samples for measurement were prepared according to the following method. The ultraviolet-radiation-curable pressure-sensitive acrylic adhesive solution prepared in each of Examples and Comparative Examples was applied to the separator and then dried at 100°C for 3 minutes to from a pressure sensitive adhesive layer with a post-drying thickness of 50 $\mu m$. A 2 kg hand roller was used to uniformly press the surface until the total thickness of the separator and the pressure sensitive adhesive layer reached 3 mm. In order to defoam the sample, autoclaving was performed under the conditions of a temperature of 50°C and a pressure of 5 kg/cm$^2$ so that each sample was prepared.
The viscoelasticity of the pressure sensitive adhesive layer was measured with ARES (trade name) manufactured by Rheometric Scientific, Inc. under the conditions of $\omega$ = 1 Hz, plate diameter: 7.9 mm$\phi$, and distortion: 1% (25°C) at temperatures ranging from -5 to 75°C. A loss tangent (tan 8) was calculated from the values of the storage modulus G' and the loss modulus G '' at 25°C or 50°C obtained by the measurement, according to the formula tan $\delta$ = G '' /G'.

Measurement of Contact Angle of Water on Pressure-Sensitive Adhesive Layer Surface

In an image processing type contact angle meter (trade name: FACE Contact Angle Meter CA-X model), the pressure-sensitive adhesive sheet for dicing obtained in each of Examples and Comparative Examples was placed with the pressure sensitive adhesive layer side facing upward, and a drop of water was placed on the surface of the pressure-sensitive adhesive layer with a syringe. One minute after the dropping, the contact angle was measured. As a result of the measurement, contact angles of 90° or less were evaluated as good, and those of more than 90° as poor. Total Evaluation
In the total evaluation, the case where all of the evaluations of the pickup, loss tangent tan $\delta$, contact angle of water, adhesive force, and increase in surface organic contaminants ($\Delta C$) were good was evaluated as good, and the other cases where at least one of the evaluations was poor were evaluated as poor. Table 1 below demonstrates that the pressure sensitive adhesive sheets of Examples 1 and 2 for dicing enable good pickup of all the semiconductor chips even 6 hours or 1 week after the mounting and produce good pickup performance. It is also demonstrated that the pressure sensitive adhesive sheets of Examples 1 and 2 provide a very small amount of increase in surface organic contaminants ($\Delta C$) and can reduce the incidence of adhesive deposit and have good performance against contamination. In contrast, none of the pressure sensitive adhesive sheets of Comparative Examples 1 to 4 for dicing were satisfactory in both of the pickup performance and the performance against contamination.

**Table 1**

| | | Example 1 | Example 2 | Example 3 | Comparative Example 1 | Comparative Example 2 | Comparative Example 3 | Comparative Example 4 |
|---|---|---|---|---|---|---|---|---|
| Pickup | 6 Hours After Mounting (count) | 50 | 50 | 50 | 32 | 28 | 50 | 50 |
| | Evaluation | Good | Good | Good | Poor | Poor | Good | Good |
| | 1 Week After Mounting (count) | 50 | 50 | 50 | 3 | 0 | 35 | 50 |
| | Evaluation | Good | Good | Good | Poor | Poor | Poor | Good |
| tan δ | Measurement at 25°C | 0.35 | 0.45 | 0.42 | 0.69 | 0.59 | 0.55 | 0.63 |
| | at 25°C Measurement at 50°C | 0.05 | 0.10 | 0.08 | 0.28 | 0.22 | 0.18 | 0.24 |
| Contact Angle of Water | Measurement (degrees) | 90 | 82 | 75 | 110 | 108 | 103 | 105 |
| | Evaluation | Good | Good | Good | Poor | Poor | Poor | Poor |
| Adhesive Force Against 15° Peeling after UV Irradiation | Measurement (N/25 mm) | 1.8 | 1.5 | 1.1 | 2.5 | 2.7 | 2.0 | 1.3 |
| | Evaluation | Good | Good | Good | Poor | Poor | Poor | Poor |
| Increase in Surface Organic Contaminants (ΔC) | Measurement (%) | 4.6 | 3.8 | 4.1 | 5.4 | 7.6 | 4.2 | 34.7 |
| | Evaluation | Good | Good | Good | Poor | Poor | Good | Poor |
| Total Evaluation | | Good | Good | Good | Poor | Poor | Poor | Poor |

**Table 2**

| | | Example 1 | Example 2 | Example 3 | Comparative Example 1 | Comparative Example 2 | Comparative Examples 3 | Comparative Example 4 |
|---|---|---|---|---|---|---|---|---|
| Adhesive Force Against 90° Peeling on Active Surface | Measurement (N/25 mm) | 0.81 | 0.52 | 0.35 | 1.3 | 1.5 | 1.1 | 0.33 |
| | Evaluation | Good | Good | Good | Poor | Poor | Poor | Good |

Specific embodiments and examples are cited in the detailed description of the invention solely for the purpose of clarifying the technological content of the present invention, and the invention should not be interpreted in a narrow sense as being limited to these Specific examples, but rather, can be implemented with modifications within the spirit of the present invention, as well as the scope of the claims described below.

**Claims**

1. A method for processing a workpiece, according to which a workpiece is processed using a pressure-sensitive adhesive sheet for use in dicing, and which is **characterized by** comprising:

   the step of grinding the rear surface of said workpiece;
   the step of contact-bonding said pressure-sensitive adhesive sheet for use in dicing on an active surface on the rear surface of the workpiece that has been ground, wherein
   the contact-bonding is carried out within one hour after said grinding of the rear surface, or
   the contact-bonding is carried out within one hour after a further step of removing a crushed layer that has been created on the workpiece during the grinding of the rear surface of said workpiece after the grinding of the rear surface;
   the step of dicing said workpiece; and
   the step of picking up said workpiece after dicing from the pressure-sensitive adhesive sheet for use in dicing, wherein said pressure-sensitive adhesive sheet comprises:

      a base film; and
      at least a pressure-sensitive adhesive layer provided on the base film, wherein the pressure-sensitive adhesive layer comprises an acrylic polymer that contains at least 5% by weight of a monomer unit having an alkoxyl group in its side chain.

2. The method according to Claim 1, **characterized in that** a 90 degree peeling adhesiveness, which is the adhesiveness of said pressure-sensitive adhesive layer to an active surface of said workpiece, is 0.05 to 1 N/25 mm tape width when pulled and peeled under the conditions where a measurement temperature is $23\pm3°C$, an angle formed between a surface of the pressure-sensitive adhesive layer and a surface of a silicon mirror wafer is 15°, and a peeling rate is 150 mm/minute.

3. The method according to Claim 1 or 2, wherein the pressure-sensitive adhesive layer contains at least 5% by weight of a monomer unit having nitrogen in its side chain.

4. The method according to any of Claims 1 to 3, wherein the surface of the pressure-sensitive adhesive layer forms a contact angle of at most 90 degrees with water.

5. The method according to any of Claims 1 to 3, wherein the pressure-sensitive adhesive layer has a loss tangent tan $\delta$ of at most 0.5 at 25°C and a loss tangent tan $\delta$ of at most 0.15 at 50°C.

6. The method according to any of Claims 1 to 5, wherein the acrylic polymer has one carbon-carbon double bond in each of at least 1/100 of all side chains in its molecule.

7. The method according to any of Claims 1 to 6, wherein the pressure-sensitive adhesive layer comprises a radiation-curable pressure-sensitive adhesive having a carbon-carbon double bond, and
after the pressure-sensitive adhesive sheet for use in dicing is attached to a silicon mirror wafer, the pressure-sensitive adhesive layer exhibits an adhesive force of at most 2.3 N/25 mm tape width when the sheet is peeled under the conditions of a measurement temperature of $23\pm3°C$, an angle of 15° formed between the surfaces of the pressure-sensitive adhesive layer and the silicon mirror wafer, and a peeling rate of 150 mm/minute.

8. The method according to any of Claims 1 to 7, wherein the acrylic polymer has a weight average molecular weight of at least 500,000.

9. The method according to any of Claims 1 to 8, wherein the pressure-sensitive adhesive layer has such releasability that after the pressure-sensitive adhesive layer is separated from the workpiece, the attached surface of the workpiece provides at most 5% increase $\Delta C$ in surface organic contaminants.

10. The method according to any of Claims 1 to 9, wherein the workpiece is a semiconductor device with a thickness of less than 100 $\mu$m.

11. A semiconductor device produced by the method according to any of Claims 1 to 10.

**Patentansprüche**

1. Verfahren zum Verarbeiten eines Werkstücks, gemäß dessen ein Werkstück unter Verwendung eines Haftkleberblatts zur Verwendung im Schneiden verarbeitet wird, und welches **gekennzeichnet ist durch** das Umfassen des Schritts des Schleifens der Rückseite des Werkstücks;
des Schritts des Kontaktklebens des Haftkleberblatts zur Verwendung im Schneiden auf eine Aktivoberfläche auf der Rückseite des Werkstücks, das geschliffen worden ist, wobei
das Kontaktkleben innerhalb einer Stunde nach dem Schleifen der Rückseite durchgeführt wird oder
das Kontaktkleben innerhalb einer Stunde nach einem weiteren Schritt des Entfernens einer zerkleinerten Schicht, die auf dem Werkstück während des Schleifens der Rückseite des Werkstücks erzeugt wurde, nach dem Schleifen der Rückseite;
des Schritts des Schneidens des Werkstücks und
des Schritts des Trennens des Werkstücks nach dem Schneiden von dem Haftkleberblatt zur Verwendung im Schneiden,
wobei das Haftkleberblatt umfasst:

einen Grundfilm und
mindestens eine auf dem Grundfilm bereitgestellte Haftkleberschicht, wobei die Haftkleberschicht ein Acrylpolymer umfasst, das mindestens 5 Gew.-% einer Monomereinheit mit einer Alkoxygruppe in ihrer Seitenkette enthält.

2. Verfahren nach Anspruch 1, **dadurch gekennzeichnet, dass** eine 90 Grad Abziehhaftung, welche die Haftung der Haftkleberschicht an einer Aktivoberfläche des Werkstücks ist, 0,05 bis 1 N/25 mm Bandbreite beträgt, wenn unter den Bedingungen, worin eine Messtemperatur 23±3°C beträgt, ein zwischen einer Oberfläche der Haftkleberschicht und einer Oberfläche eines Siliziumspiegelwafers gebildeter Winkel 15° beträgt und eine Abziehrate 150 mm/Minute beträgt, gezogen und abgezogen wird.

3. Verfahren nach Anspruch 1 oder 2, wobei die Haftkleberschicht mindestens 5 Gew.-% einer Monomereinheit mit Stickstoff in ihrer Seitenkette enthält.

4. Verfahren nach einem der Ansprüche 1 bis 3, wobei die Oberfläche der Haftkleberschicht einen Kontaktwinkel von höchstens 90 Grad mit Wasser bildet.

5. Verfahren nach einem der Ansprüche 1 bis 3, wobei die Haftkleberschicht einen Verlustfaktor tan $\delta$ von höchstens 0,5 bei 25°C und einen Verlustfaktor tan $\delta$ von höchstens 0,15 bei 50°C aufweist.

6. Verfahren nach einem der Ansprüche 1 bis 5, wobei das Acrylpolymer eine Kohlenstoff-Kohlenstoff Doppelbindung in jeder von mindestens 1/100 aller Seitenketten in seinem Molekül aufweist.

7. Verfahren nach einem der Ansprüche 1 bis 6, wobei die Haftkleberschicht einen strahlungshärtbaren Haftkleber mit einer Kohlenstoff-Kohlenstoff Doppelbindung umfasst, und
die Haftkleberschicht, nachdem das Haftkleberblatt zur Verwendung im Schneiden an einem Siliziumspiegelwafer angebracht ist, eine Haftkraft von höchstens 2,3 N/25 mm Bandbreite aufweist, wenn das Blatt unter den Bedingungen einer Messtemperatur von 23±3°C, eines zwischen den Oberflächen der Haftkleberschicht und des Siliziumspiegelwafers gebildeten Winkels von 15° und einer Abziehrate von 150 mm/Minute abgezogen wird.

8. Verfahren nach einem der Ansprüche 1 bis 7, wobei das Acrylpolymer ein Gewichtsmittel des Molekulargewichts von mindestens 500.000 aufweist.

9. Verfahren nach einem der Ansprüche 1 bis 8, wobei die Haftkleberschicht eine solche Ablösbarkeit aufweist, dass die angehaftete Oberfläche des Werkstücks, nachdem die Haftkleberschicht von dem Werkstück abgetrennt worden ist, höchstens 5% Zunahme $\Delta$C an organischen Oberflächenverunreinigungen aufweist.

**10.** Verfahren nach einem der Ansprüche 1 bis 9, wobei das Werkstück eine Halbleitervorrichtung mit einer Dicke von weniger als 100 μm ist.

**11.** Halbleitervorrichtung, hergestellt durch das Verfahren nach einem der Ansprüche 1 bis 10.

**Revendications**

**1.** Méthode pour traiter une pièce, selon laquelle une pièce est traitée à l'aide d'une feuille adhésive sensible à la pression à utiliser pour la découpe, et qui se **caractérise en ce qu'**elle comprend :

l'étape de meulage de la surface arrière de ladite pièce ;
l'étape de collage par contact de ladite feuille adhésive sensible à la pression à utiliser dans la découpe sur une surface active sur la surface arrière de la pièce qui a été meulée, dans laquelle
le collage par contact est réalisé dans l'heure qui suit ledit meulage de la surface arrière, ou
le collage par contact est réalisé dans l'heure qui suit une autre étape consistant à enlever une couche concassée qui a été créée sur la pièce durant le meulage de la surface arrière de ladite pièce après le meulage de la surface arrière ;
l'étape de découpe de ladite pièce; et
l'étape de ramassage de ladite pièce après la découpe sur la feuille adhésive sensible à la pression à utiliser pour la découpe,
dans laquelle ladite feuille adhésive sensible à la pression comprend:

un film de base; et
au moins une couche adhésive sensible à la pression présente sur le film de base, dans laquelle la couche adhésive sensible à la pression comprend un polymère acrylique qui contient au moins 5% en poids d'une unité monomère ayant un groupe alkoxyle dans sa chaîne latérale.

**2.** La méthode selon la revendication 1, **caractérisée en ce qu'**une force d'adhésion au pelage à 90 degrés, qui est la force d'adhésion de ladite couche adhésive sensible à la pression à une surface active de ladite pièce, est de 0,05 à 1 N/largeur de ruban de 25 mm lorsqu'il y a traction et pelage dans les conditions où la température de mesure est de 23±3°C, l'angle formé entre une surface de la couche adhésive sensible à la pression et une surface d'une plaquette de silicium polie est de 15, et la vitesse de pelage est de 150 mm/minute.

**3.** La méthode selon la revendication 1 ou 2, dans laquelle la couche adhésive sensible à la pression contient au moins 5% en poids d'une unité monomère ayant de l'azote dans sa chaîne latérale.

**4.** La méthode selon l'une quelconque des revendications 1 à 3, dans laquelle la surface de la couche adhésive sensible à la pression forme un angle de contact d'au plus 90 degrés avec l'eau.

**5.** La méthode selon l'une quelconque des revendications 1 à 3, dans laquelle la couche adhésive sensible à la pression a une tangente de perte tan δ d'au plus 0,5 à 25°C et une tangente de perte tan δ d'au plus 0,15 à 50°C.

**6.** La méthode selon l'une quelconque des revendications 1 à 5, dans laquelle le polymère acrylique a une liaison double carbone-carbone dans chacune d'au moins 1/100 de toutes les chaines latérales dans sa molécule.

**7.** La méthode selon l'une quelconque des revendications 1 à 6, dans laquelle la couche adhésive sensible à la pression comprend un adhésif sensible à la pression durcissable par rayonnement ayant une double liaison carbone-carbone, et
après que la feuille adhésive sensible à la pression à utiliser pour la découpe est attachée à une plaquette de silicium polie, la couche adhésive sensible à la pression affiche une force d'adhésion d'au plus 2,3 N/largeur de ruban de 25 mm lorsque la feuille est pelée dans les conditions d'une température de mesure de 23±3°C, un angle de 15° formé entre les surfaces de la couche adhésive sensible à la pression et la plaquette de silicium polie, et une vitesse de pelage de 15.0 mm/minute.

**8.** La méthode selon l'une quelconque des revendications 1 à 7, dans laquelle le polymère acrylique a un poids moléculaire moyen pondéral d'au moins 500.000.

**9.** La méthode selon l'une quelconque des revendications 1 à 8, dans laquelle la couche adhésive sensible à la pression a une aptitude au décollement telle qu'après que la couche adhésive sensible à la pression a été séparée de la pièce, la surface attachée de la pièce fournit au plus 5% d'augmentation $\Delta C$ en contaminants organiques de surface.

**10.** La méthode selon l'une quelconque des revendications 1 à 9, dans laquelle la pièce est un dispositif semi-conducteur d'une épaisseur de moins de 100 $\mu$m.

**11.** Un dispositif semi-conducteur produit par la méthode selon l'une quelconque des revendications de 1 à 10.

**FIG.1**

**FIG.2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001234136 A